# EUROPEAN PATENT APPLICATION

(11) **EP 4 718 988 A1**
(43) Date of publication of application: **01.04.2026**
(21) Application number: 24202568.2
(22) Date of filing: 25.09.2024
(51) Int. Cl.: H10D 64/64, H10D 64/01, H01L 21/285, H10D 8/60, H01L 21/04, H10D 30/66

(54) **METHOD FOR PRODUCING A FIRST CONTACT LAYER AND A SECOND CONTACT LAYER ON A POWER SEMICONDUCTOR BODY, AND POWER SEMICONDUCTOR DEVICE**

(71) Applicant: Hitachi Energy Ltd, 8050 Zürich (CH)
(72) Inventor: ALFIERIi, Giovanni, 5103 Möriken (CH); POCATERRA, Marco Pietro Marcello, 5603 Staufen (CH); BOLAT, Sami, 5630 Muri (CH); FERNANDEZ, Stephanie, 1418 Vuarrens (CH)
(74) Representative: Epping - Hermann - Fischer

(57) **Abstract**

A method for producing a first contact layer (5) and a second contact layer (6) on a power semiconductor body (2) is specified, comprising:
- providing the power semiconductor body (2), comprising a substrate region (3) with a bottom surface and an epitaxial body region (4) with a top surface facing away from the bottom surface,
- applying a first layer on the top surface and applying a second layer on the bottom surface, wherein the first layer comprises a first material comprising titanium,
- incorporating a further material into the first layer, wherein the further material comprises phosphorus, and
- annealing the power semiconductor body (2) with the first layer comprising the further material and the second layer for a predetermined time interval at a predetermined annealing temperature, such that the first layer and the further material form the first contact layer (5) being a titanium-phosphorus alloy and the second layer forms a second contact layer (6).

Furthermore, a power semiconductor device (1) is specified.

## Description

The present disclosure relates to a method for producing a first contact layer and a second contact layer on a power semiconductor body, and to a power semiconductor device.

Typically, for a metallization on a typical power semiconductor body a two-step process is performed, wherein an ohmic contact is deposited, being followed by depositing a different metal in order to obtain a Schottky contact.

An objective of the disclosure is to provide a method by means of which contacts can be produced on a power semiconductor body particularly efficiently. A further embodiment relates to a power semiconductor device having such contacts.

This is achieved by the subject-matter of the independent claims. Further embodiments are evident from the dependent claims and the following description.

The method for producing a first contact layer and a second contact layer on a power semiconductor body is described. The term "power" here and in the following refers, for example, to power semiconductor chips particularly comprised by a power electronic component adapted for processing voltages and currents of more than 100 V and/or more than 10 A, exemplarily voltages of up to 10 kV and electrical currents of up to 10 kA.

The power semiconductor body is, for example, a core structure of a power semiconductor device. Exemplarily, the power semiconductor device comprising the power semiconductor body is at least one of a Schottky diode, a bipolar junction transistor, BJT, a power junction field-effect transistor, JFET, a power metal-oxide-semiconductor field-effect transistor, MOSFET. The power semiconductor body comprises or consists of a wide-bandgap semiconductor material, for example.

Exemplarily, the first contact layer and the second contact layer are each configured to be contactable externally. Further, the first contact layer and the second contact layer are in particular configured to provide a current to the power semiconductor body. The first contact layer and the second contact layer each comprise or consist of a metal, for example.

According to an embodiment of the method, the power semiconductor body is provided, comprising a substrate region with a bottom surface and an epitaxial body region with a top surface facing away from the bottom surface. Exemplarily, the power semiconductor body has a main extension plane extending in lateral directions. A vertical direction is oriented perpendicular to the lateral directions. In particular, the substrate region and the epitaxial body region each have a main extension plane extending in lateral directions. Exemplarily, the substrate region and the epitaxial body region are stacked above one another, along the vertical direction.

The substrate region has, for example, the bottom surface and a top surface being connected by at least one side surface. The epitaxial body region has, for example, a bottom surface and the top surface being connected by at least one side surface. The top surface of the substrate is particularly in direct contact with the bottom surface of the epitaxial body region. In particular, the bottom surface of the substrate region and the top surface of the epitaxial body region are freely accessible when provided.

A thickness in the vertical direction of the substrate region is larger by at least one order of magnitude than a thickness in the vertical direction of the epitaxial body region. Exemplarily, the thickness of the substrate region is at least 100 um or at least 300 um and/or at most 800 um or at most 500 um. Exemplarily, the thickness of the epitaxial body region is at least 1 um or at least 5 um and/or at most 50 um or at most 30 um.

For example, the epitaxial body region is epitaxially grown on the substrate region. In particular, the substrate region is a growth substrate for the epitaxial body region. In particular, the substrate region provides a mechanical support for the epitaxial body region. Exemplarily, a defect density of the epitaxial body region is smaller by at least one order of magnitude than a defect density of the substrate region.

Exemplarily, the substrate region comprises at least one dopant of a first type with a maximal first concentration. For example, the first type is characteristic of an n-type. Exemplarily, the epitaxial body region comprises at least one dopant of the first type with a maximal second concentration.

For example, the maximal first concentration is larger by at least one order of magnitude than the maximal second concentration. In particular, the substrate region corresponds to an n⁺-doped substrate region, and at least a part of the epitaxial body region corresponds to an n⁻-doped epitaxial body region, forming particularly a drift layer.

Exemplarily, the epitaxial body region comprises at least one dopant of a second type in a well region. For example, the first type is characteristic of a p-type. The well region extends, for example, from the top side of the epitaxial body region up to a predetermined depth in the drift layer.

Exemplarily, the epitaxial body region comprises at least one further dopant of the first type in a contact region with a maximal further first concentration. The contact region extends, for example, from the top side of the epitaxial body region in the well region up to a predetermined depth in the well region. In particular, the predetermined depth of the well region is larger than the predetermined depth of the contact region. The contact region is particularly embedded in the well region and/or the well region is particularly embedded in the drift layer. Exemplarily, top surfaces of the contact region and/or the well region are part of the top surface of the epitaxial body region.

For example, the further dopant of the first type is equal to the dopant of the first type, and the maximal first concentration is equal to or higher than at least 50% than the maximal further first concentration. In particular, the contact region corresponds to an n⁺-doped contact region.

According to the embodiment of the method, a first layer is applied on the top surface and a second layer is applied on the bottom surface, wherein the first layer comprises a first material comprising titanium. The first layer and the second layer are each in particular a metallic layer. The second layer comprises a second material. The first material can be the same as or different from the second material.

A thickness in the vertical direction of the first layer is, for example, at least 10 nm or at least 30 nm and/or at most 100 nm or at most 80 nm, such as approximately 60 nm or 70 nm.

Exemplarily, the first layer comprises the first material with a purity of at least 990, particularly at least 99.99%. In particular, the first layer exclusively consists of titanium. "Exclusively consists" means here that the first layer comprises solely titanium with a purity of at least 990, particularly at least 99.99%. Due to production tolerances, other substances can be comprised by the first layer by at most 1% or at most 0.01%.

According to the embodiment of the method, a further material is incorporated into the first layer, wherein the further material comprises phosphorus. Exemplarily, the further material is incorporated into the first layer down to a predetermined depth in the first layer. The predetermined depth extends, for example, from a top surface of the first layer in the vertical direction towards the epitaxial body region. The predetermined depth is, for example, at least 50% or at least 70% and/or at most 95% or at most 90% of the thickness of the first layer. Alternatively, the predetermined depth equals the complete thickness of the first layer.

According to the embodiment of the method, the power semiconductor body with the first layer comprising the further material and the second layer is annealed for a predetermined time interval at a predetermined annealing temperature, such that the first layer and the further material form the first contact layer being a titanium-phosphorus alloy and the second layer forms a second contact layer. In particular, the titanium-phosphorus alloy is formed of the first material and the further material during the annealing step. Exemplarily, the first contact layer corresponds geometrically to the first layer. For example, the second contact layer corresponds geometrically to the second layer.

For example, the first contact layer comprises or consists of the titanium-phosphorus alloy. In particular, due to the annealing, the first material and the further material are homogeneously distributed in the first contact layer.

In particular, an electrical contact property of a first type of the first contact layer is different from an electrical contact property of a second type of the second contact layer. Exemplarily, the electrical contact property of the first type of the first contact is characteristic of a Schottky contact and the electrical contact property of the second type of the second contact is characteristic of an ohmic contact after annealing the power semiconductor body with the first layer with the further material and the second layer.

In sum, two contacts having different electrical contact properties with respect to the power semiconductor body can be produced by the method advantageously simultaneously.

According to a further embodiment of the method, a first interface between the epitaxial body and the first contact layer is formed of a Schottky contact, and a second interface between the substrate and the second contact layer is formed of an ohmic contact. Advantageously, the Schottky contact and the ohmic contact are producible in a single method step.

According to a further embodiment of the method, a barrier height of the first contact layer is higher by at least 50% than a barrier height of the second contact layer. Exemplarily, a barrier height of the first layer comprising the first material is smaller by at least 50% than a barrier height of the first contact layer. In particular, the titanium-phosphorus alloy has the increased barrier height in comparison to the first layer comprising the titanium. Advantageously, the formation of the titanium-phosphorus alloy allows the increase of the respective barrier height of the Schottky contact in contrast to titanium.

Exemplarily, the barrier height of the first contact layer with the first material is approximately 0.9 eV, and the barrier height of the titanium-phosphorus alloy is approximately 1.9 eV. The introduction of phosphorus in the titanium, for alloy formation, is beneficial in terms of leakage current. In particular, such an alloy formation advantageously leads to a higher barrier height as well as to a lower leakage current in power semiconductor devices.

According to a further embodiment of the method, the further material is incorporated in the first layer by using a plasma comprising the further material. The further material is, in particular, incorporated by plasma-immersion ion implantation.

Exemplarily, the plasma is a diphosphorus P₂ plasma. A concentration of the further material in the plasma is at least 10¹⁴ cm⁻² and/or at most 10¹⁸ cm⁻². Exemplarily, the power semiconductor body is biased with a negative voltage of at least 5 kV and/or at most 10 kV, for implanting the further material in the first layer.

According to a further embodiment of the method, the further material is incorporated in the first layer by using low energy implantation. Exemplarily, phosphorus ions are accelerated towards the power semiconductor body, e.g. with at least 5 keV and/or at most 50 keV, for implanting the further material in the first layer. A concentration of the phosphorus ions is at least 10¹⁴ cm⁻² and/or at most 10¹⁸ cm⁻².

According to a further embodiment of the method, the first layer is applied onto at least one partial region of the top surface. Exemplarily, the first material is, for example, applied to the partial region on the top surface of the epitaxial body region. Exemplarily, the top surface of the epitaxial body region is free of the first material in places where the first material is not applied to the partial region.

For example, the first material is applied to the partial region on the top surface of the epitaxial body region via a mask. In particular, the first material is applied such that the first material is in direct contact with the drift layer, the well region and/or the contact region.

The second material is, for example, applied to a region on the bottom surface of the substrate region. For example, the second material is applied on the bottom surface of the substrate region such that the second material covers at least 800, or at least 90% of the bottom surface, exemplarily completely covers the bottom surface of the substrate region.

The first material and/or the second material is exemplarily applied by a physical vapor deposition method, such as sputtering and/or thermal evaporation.

According to a further embodiment of the method, the further material is applied only onto the first layer by using a mask. In particular, the mask prevents the further material from being incorporated in the semiconductor material of the power semiconductor body in places where the first layer is not arranged.

According to a further embodiment of the method, the further material is applied onto the first layer and onto regions of the top surface not covered by the first layer. In particular, the further material is also incorporated in the semiconductor material of the power semiconductor body in places where the first layer is not arranged. Exemplarily, the further material is incorporated in the drift region, particularly the top surface thereof.

Advantageously, when using the further material, e.g. phosphorus, this has particularly no substantial impact on a resistivity of the power semiconductor body.

Additionally, using the further material, e.g. phosphorus, at the top surface of the power semiconductor body advantageously leads to a diffusion of carbon interstitials that, occupying empty C sites, lead to the annihilation of carbon vacancies, VC. Thus, advantageously, by applying the further material on the power semiconductor body, carbon vacancies in the power semiconductor body can be reduced, and thus, a leakage current is reduced as well in power semiconductor devices.

According to a further embodiment of the method, the second layer comprises a second material comprising titanium and/or nickel.

Exemplarily, the second material is exclusively formed of the first material. When the second material is exclusively formed of the first material, the first layer and the second layer consist of the same material, namely titanium.

Alternatively, the second material comprises or consists of nickel or a bilayer comprising a first sublayer comprising or consisting of titanium and a second sublayer comprising or consisting of nickel.

Advantageously, by using titanium and/or nickel, the ohmic contact is produced during annealing.

According to a further embodiment of the method, the predetermined time interval is at least 1 minute and at most 10 minutes.

According to a further embodiment of the method, the predetermined annealing temperature is at least 900°C and at most 1100°C.

By using such a predetermined time interval and/or such a predetermined annealing temperature, the Schottky contact as well as the ohmic contact is advantageously produced. In addition, when the further material is also arranged on the power semiconductor body, the temperature range of the predetermined annealing temperature advantageously does not lead to an n+ formation, because for this at least 1600°C are needed.

According to a further embodiment of the method, the power semiconductor body is based on silicon carbide or gallium nitride.

A further embodiment relates to a power semiconductor device, in particular comprising a first contact layer and a second contact layer being produced or being producible by the method as described herein above. Therefore, the features as described in connection with the power semiconductor device are also applicable to the method and vice versa.

According to an embodiment, the power semiconductor device comprises a power semiconductor body comprising a substrate region with a bottom surface and an epitaxial body region with a top surface facing away from the bottom surface.

According to the embodiment, the power semiconductor device comprises a first contact layer arranged on the top surface.

According to the embodiment, the power semiconductor device comprises a second contact layer arranged on the bottom surface.

According to the embodiment of the power semiconductor device, the first contact layer comprises a titanium-phosphorus alloy.

Advantageously, with such a first contact layer, a Schottky contact is provided, which effectively reduces the leakage current in power semiconductor devices compared to titanium contact layers.

According to the embodiment of the power semiconductor device, the epitaxial body region comprises an n-type doped region.

According to the embodiment of the power semiconductor device, the n-type doped region and the first contact layer are in direct contact with one another for forming a first interface. In particular, the first interface between the epitaxial body and the first contact layer is formed of a Schottky contact.

According to the embodiment of the power semiconductor device, the power semiconductor body is based on silicon carbide of a 4H polytype or a 6H polytype.

In particular, the designation "4H" indicates that the corresponding polytype is a hexagonal polytype characteristic of a hexagonal crystal structure. The hexagonal 4H polytype has, in particular, a periodicity of 4 in a stacking sequence along a c-axis of a hexagonal unit cell. This means that the silicon carbide having the hexagonal 4H polytype has a repeating sequence every four bilayers of silicon and carbon atoms.

In particular, the designation "6H" indicates that the corresponding polytype is a hexagonal polytype characteristic of a hexagonal crystal structure. The hexagonal 6H polytype has, in particular, a periodicity of 6 in a stacking sequence along a c-axis of a hexagonal unit cell. This means that the silicon carbide having the hexagonal 46 polytype has a repeating sequence every sixth bilayers of silicon and carbon atoms.

According to the embodiment of the power semiconductor device, the power semiconductor body is based on gallium nitride.

The accompanying Figures are included to provide a further understanding. In the Figures, elements of the same structure and/or functionality may be referenced by the same reference signs. It is to be understood that the embodiments shown in the Figures are illustrative representations and are not necessarily drawn to scale.

Figure 1 shows a flow chart of the method according to an exemplary embodiment.

Figures 2, 3 and 4 each shows a schematic view of a power semiconductor device according to an exemplary embodiment.

Figure 5 shows a schematic view of a power semiconductor device being a Schottky diode according to an exemplary embodiment.

Figures 6 and 7 each shows a simulated diagram of a power semiconductor device according to an exemplary embodiment.

Figure 8 shows a schematic view of a power semiconductor device being a MOSFET according to an exemplary embodiment.

Figure 9 shows a simulated diagram of a power semiconductor device according to an exemplary embodiment.

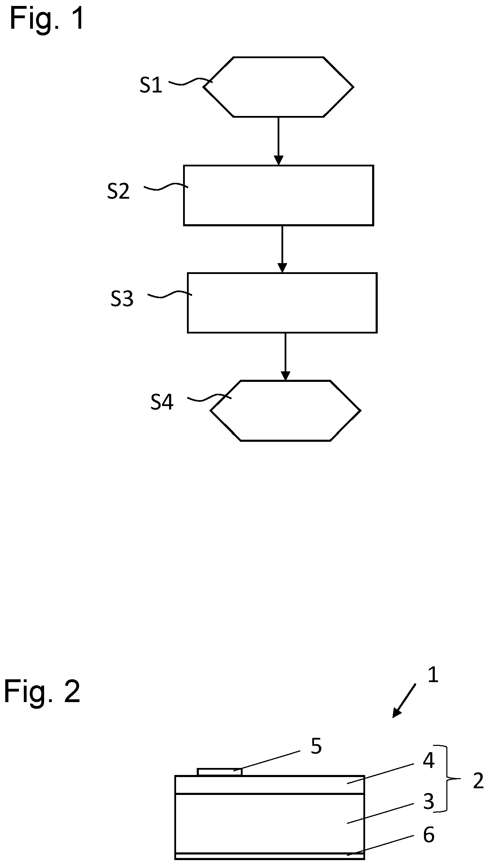

In the method stage S1 according to the exemplary embodiment of Figure 1, a power semiconductor body 2 is provided, comprising a substrate region 3 with a bottom surface and an epitaxial body region 4 with a top surface facing away from the bottom surface.

Subsequently, in method stage S2, a first layer is applied on the top surface and a second layer is applied on the bottom surface, wherein the first layer comprises a first material comprising titanium.

In method stage S4, a further material is incorporated into the first layer, wherein the further material comprises phosphorus.

Subsequently, in method stage S4, the power semiconductor body 2 with the first layer comprising the further material and the second layer is annealed for a predetermined time interval at a predetermined annealing temperature, such that the first layer and the further material form the first contact layer 5 being a titanium-phosphorus alloy and the second layer forms a second contact layer 6.

In particular, the power semiconductor body 2 can be preprocessed before applying the first and/or the second contact layer 6. The preprocessing involves the generation of specific doped regions in the power semiconductor body 2.

The power semiconductor device 1 according to Figure 2 comprises the power semiconductor body 2 with the first contact layer 5 and the second contact layer 6, being in particular produced by the method described in connection with Figure 1. The power semiconductor body 2 comprises the substrate region 3 and the epitaxial body region 4, which are stacked above one another along a stacking direction being particularly parallel to a vertical direction. The vertical direction is perpendicular to the main extension planes of the substrate region 3 and the epitaxial body region 4.

The substrate region 3 comprises at least one dopant of a first type with a predetermined maximal first concentration, wherein the first type is an n-type. The epitaxial body region 4 comprises at least one dopant of the first type with a predetermined maximal second concentration. The predetermined maximal first concentration is larger by at least one order of magnitude than the predetermined maximal second concentration.

An n⁺-doped substrate region 3 of the power semiconductor device 1 corresponds particularly to the substrate region 3. A drift layer of the power semiconductor device 1, particularly an n⁻-doped epitaxial body region 4, corresponds to at least a part of the epitaxial body region 4.

The first contact layer 5 is in direct contact with the epitaxial body region 4, particularly the drift layer being the n -doped epitaxial body region 4. In this region, a first interface between the epitaxial body and the first contact layer 5 is formed of a Schottky contact. A second interface between the substrate and the second contact layer 6 is formed of an ohmic contact, wherein both different functional contacts are formed in the single annealing step according to Figure 1.

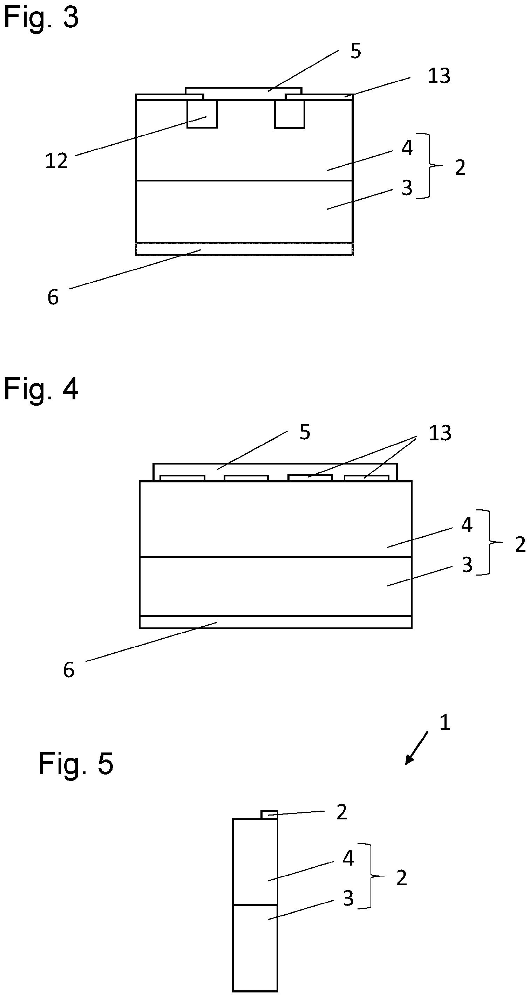

The power semiconductor device 1 according to Figure 3 is a is a Schottky diode comprising the n⁺-doped substrate region 3 and the n -doped epitaxial body region 4. The n⁺-doped substrate region 3 has a maximal first concentration of a dopant of a first type being approximately 10¹⁸ cm⁻³ and the n-doped epitaxial body region 4 has a maximal second concentration of a dopant of the first type being approximately 10¹⁶ cm⁻³.

Further, the power semiconductor body 2 comprises at least one further dopant of a second type in a further region 12, which is embedded in epitaxial body region 4. The further region 12 is particularly a p⁺-doped further region 12. The p⁺-doped further region 12 has a maximal third concentration of a dopant of the second type being at least 10¹⁴ cm⁻³ and at most 10¹⁶ cm⁻³.

The first contact layer 5 is arranged above the power semiconductor body 2 being at least regionally in direct contact to the n⁻-doped epitaxial body region 4 and the p⁺-doped further region 12. An oxide layer 13 is arranged, at least regionally, between the power semiconductor body 2 and the first contact layer 5.

The power semiconductor device 1 according to Figure 4 is a MOSFET, wherein a structured oxide 13 layer is arranged in regions between the power semiconductor body 2 and the first contact layer 5.

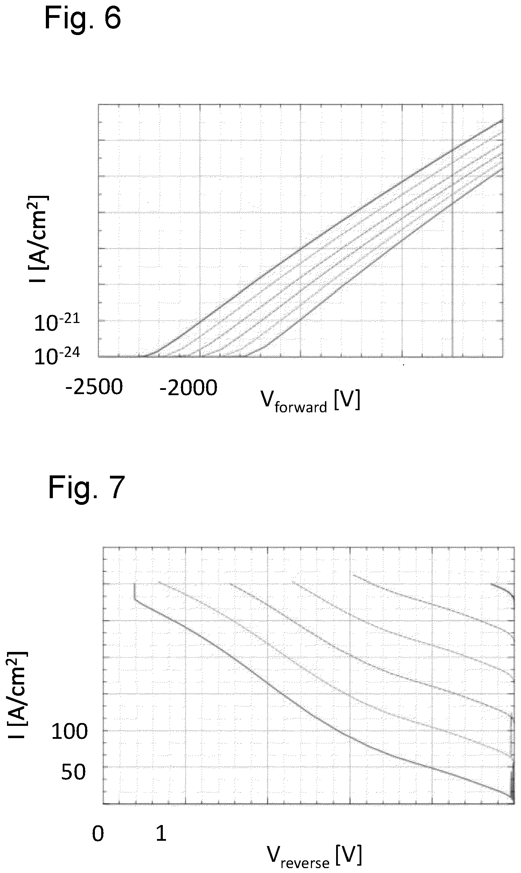

The power semiconductor device 1 according to Figure 5 is a Schottky diode. For such a Schottky diode, a current voltage characteristic is simulated for different barrier heights of the first contact layer 5, as shown in connection with Figures 6 and 7.

On the y axis of Figures 6 and 7, a current I in A/cm² is indicated and on the x axis of Figure 6, a forward voltage V_{forward} in V is indicated and on the x axis of Figure 7, a reverse voltage Vᵣₑᵥₑᵣₛₑ in V is indicated. The upper curve is characteristic of a comparatively low barrier height and the lower curve is characteristic of a comparatively high barrier height. Advantageously, by increasing the barrier height, improved forward and blocking voltage characteristics can be achieved. In particular, an improved on-state resistance and lower leakage current are achieved by increasing the barrier height, i.e. with a titanium phosphorus alloy for the first contact layer 5.

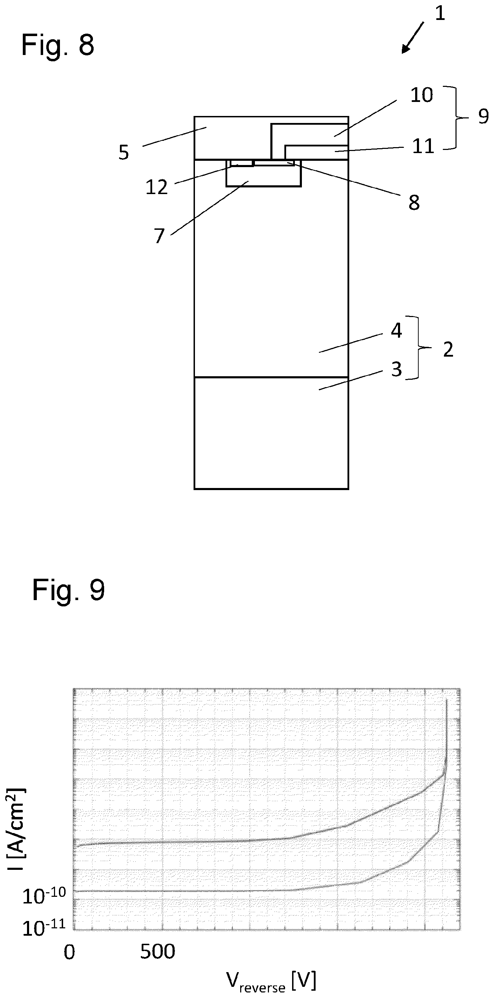

The power semiconductor device 1 according to Figure 8 is a MOSFET. The epitaxial body region 4 comprises at least one dopant of a second type in a well region 7, which is different from the first type. The well region 7 is embedded in the drift layer. In particular, the well region 7 is a p-well region. Further, the epitaxial body region 4 comprises at least one further dopant of the first type in a contact region 8, which is embedded in the well region 7. A gate 9 comprising a gate metal 10 and a gate oxide 11 are provided partly on the contact region 8, the well region 7, and the drift region arranged next to the contact region 8.

Further, the epitaxial body region 4 comprises at least one further dopant of the second type in a further region 12, which is embedded in the well region 7 and located adjacent to the contact region 8.

The first contact layer 5 is in direct contact with the contact region 8, the further region 12 and the drift layer. Advantageously, when forming the first contact layer 5 at the top surface, simultaneously a Schottky contact and ohmic contact formation is achieved, allowing for bipolar degradation avoidance while preserving blocking performance. Particularly, the first interface between the first contact layer 5 and the contact region 8 and/or the drift layer is characteristic of the Schottky contact, and a further first interface between the first contact layer 5 and the well region 7 is characteristic of the ohmic contact.

For such a MOSFET, a current voltage characteristic is simulated for different barrier heights of the first contact layer 5, as shown in connection with Figure 9.

On the y axis of Figure 9, a current I in A/cm² is indicated and on the x axis of Figure 9, a reverse voltage Vᵣₑᵥₑᵣₛₑ in V is indicated. The upper curve is characteristic of a comparatively low barrier height and the lower curve is characteristic of a comparatively high barrier height. A leakage current is smaller by about two orders of magnitude for the lower curve corresponding to the first contact layer 5 comprising the titanium phosphorus alloy.

The exemplary embodiments, in particular features of the exemplary embodiments, of the Figures can be combined with one another.

### Reference Signs

- 1: power semiconductor device
- 2: power semiconductor body
- 3: substrate region
- 4: epitaxial body region
- 5: first contact layer
- 6: second contact layer
- 7: well region
- 8: contact region
- 9: gate
- 10: gate metal
- 11: gate oxide
- 12: further region
- 13: oxide layer

- S1..S4: method stages

## Claims

1. Method for producing a first contact layer (5) and a second contact layer (6) on a power semiconductor body (2), comprising:
- providing the power semiconductor body (2), comprising a substrate region (3) with a bottom surface and an epitaxial body region (4) with a top surface facing away from the bottom surface,
- applying a first layer on the top surface and applying a second layer on the bottom surface, wherein the first layer comprises a first material comprising titanium,
- incorporating a further material into the first layer, wherein the further material comprises phosphorus, and
- annealing the power semiconductor body (2) with the first layer comprising the further material and the second layer for a predetermined time interval at a predetermined annealing temperature, such that the first layer and the further material form the first contact layer (5) being a titanium-phosphorus alloy and the second layer forms a second contact layer (6).

2. Method according to claim 1, wherein
- a first interface between the epitaxial body and the first contact layer (5) is formed of a Schottky contact, and a second interface between the substrate and the second contact layer (6) is formed of an ohmic contact.

3. Method according to claim 1 or 2, wherein
- a barrier height of the first contact layer (5) is higher by at least 50% than a barrier height of the second contact layer (6).

4. Method according to any one of claims 1 to 3, wherein
- the further material is incorporated in the first layer by using a plasma comprising the further material.

5. Method according to any one of claims 1 to 3, wherein
- the further material is incorporated in the first layer by using low energy implantation.

6. Method according to any one of claims 1 to 5, wherein
- the first layer is applied onto at least one partial region of the top surface.

7. Method according to any one of claims 1 to 6, wherein
- the further material is applied only onto the first layer by using a mask.

8. Method according to any one of claims 1 to 6, wherein
- the further material is applied onto the first layer and onto regions of the top surface not covered by the first layer.

9. Method according to any one of claims 1 to 8, wherein
- the second layer comprises a second material comprising titanium and/or nickel.

10. Method according to any one of claims 1 to 9, wherein
- the predetermined time interval is at least 1 minute and at most 10 minutes.

11. Method according to any one of claims 1 to 10, wherein
- the predetermined annealing temperature is at least 900°C and at most 1100°C.

12. Method according to any one of claims 1 to 11, wherein
- the power semiconductor body (2) is based on silicon carbide or gallium nitride.

13. Power semiconductor device (1), comprising
- a power semiconductor body (2) comprising a substrate region (3) with a bottom surface and an epitaxial body region (4) with a top surface facing away from the bottom surface,
- a first contact layer (5) arranged on the top surface, and
- a second contact layer (6) arranged on the bottom surface, wherein
- the first contact layer (5) comprises a titanium-phosphorus alloy.

14. Power semiconductor device (1) according to claim 13, wherein
- the epitaxial body region (4) comprises an n-type doped region, and
- the n-type doped region and the first contact layer (5) are in direct contact with one another for forming a first interface.

15. Power semiconductor device (1) according to claim 14, wherein
- the power semiconductor body (2) is based on silicon carbide of a 4H polytype or a 6H polytype, or
- the power semiconductor body (2) is based on gallium nitride.
